Europäisches Patentamt

European Patent Office

Office européen des brevets

(11) Publication number: 0 689 290 A1

# EUROPEAN PATENT APPLICATION

(21) Application number: 95109742.7

(22) Date of filing: 22.06.95

(51) Int. Cl.6: H03K 5/15

(30) Priority: 22.06.94 JP 162900/94

(43) Date of publication of application:
27.12.95 Bulletin 95/52

(84) Designated Contracting States:
DE FR GB

(71) Applicant: NEC CORPORATION
7-1, Shiba 5-chome
Minato-ku
Tokyo (JP)

(72) Inventor: Kaneko, Shigeharu
c/o NEC Corporation,
7-1, Shiba 5-chome
Minato-ku,
Tokyo (JP)

(74) Representative: Betten & Resch
Reichenbachstrasse 19
D-80469 München (DE)

(54) Semiconductor integrated circuit having reset circuit

(57) In a semiconductor integrated circuit (1B,1C) having a reset circuit (4B,4C), the semiconductor integrated circuit (1B,1C) excluding the reset circuit (4B,4C) is divided into a plurality of logic circuit units (3A...3E), and the reset circuit (4B,4C) is configured to generate at different timings a plurality of internal reset signals (6,6A...6D), which are supplied to the plurality of logic circuit units (3A...3E), respectively. With this arrangement, the increased current peak at the time of a resetting can be decreased, so that the noises appearing on the power supply voltage and the ground voltage can be suppressed and a latch-up phenomenon can be prevented.

FIGURE 3

EP 0 689 290 A1

## Background of the Invention

### Field of the invention

The present invention relates to a semiconductor integrated circuit, and more specifically to a semiconductor integrated circuit having a reset circuit.

### Description of related art

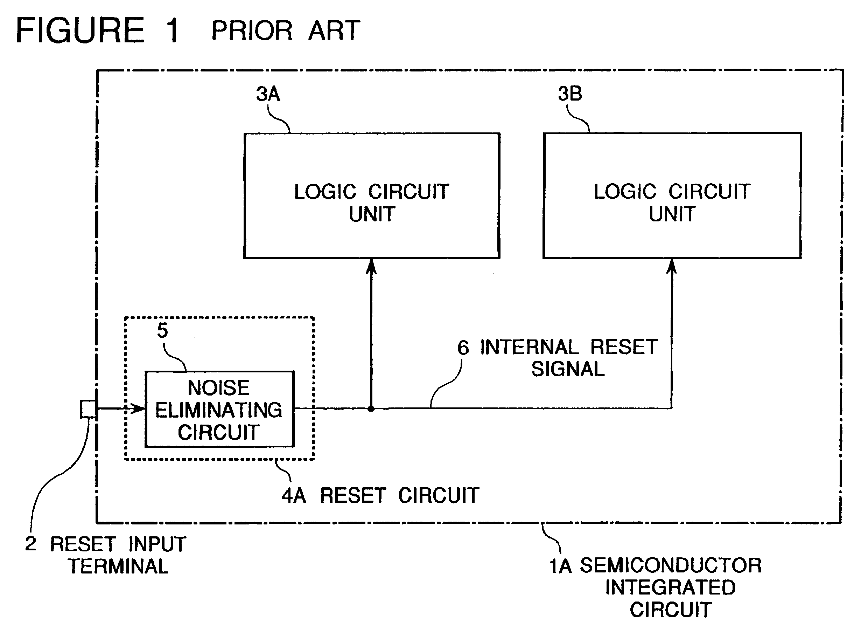

In the prior art, a semiconductor integrated circuit having a reset circuit is so configured as shown in Figure 1 that a reset signal applied through a reset input terminal 2 of a semiconductor integrated circuit 1A is caused to pass through a noise eliminating circuit 5 and then applied to all various internal logic circuit units within the semiconductor integrated circuit 1A at the same timing. Here, the semiconductor integrated circuit 1A actually includes a number of logic circuit units, but only two logic circuit units 3A and 3B are shown in Figure 1 for simplification of the drawing.

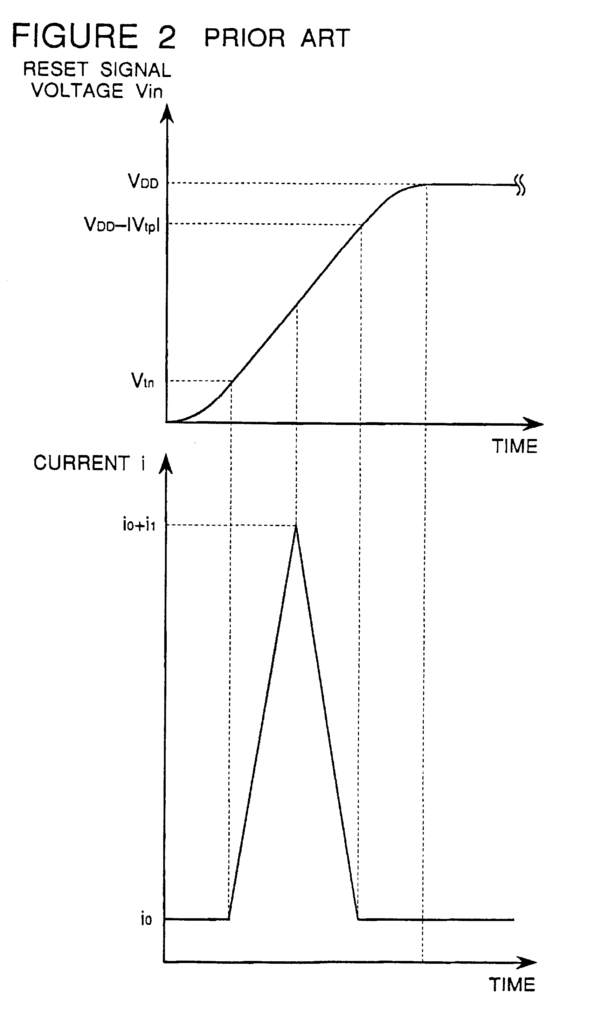

In the circuit shown in Figure 1, if the reset signal is applied to the reset input terminal 2, an internal reset signal 6 is generated from an internal reset circuit 4A, and the internal logic circuit units 3A and 3B are simultaneously reset by the internal reset signal 6. In other words, all the internal logic circuit units internally included in the semiconductor integrated circuit 1A excluding the reset circuit 4A are reset simultaneously. As a result, When the reset signal is applied, a consumed current of the semiconductor integrated circuit 1A increases by $i_1$ as shown in Figure 2.

In Figure 2, $i_1$ represents an increased amount of the consumed current of the semiconductor integrated circuit 1A when all the internal logic circuit units 3A and 3B are simultaneously reset by the internal reset signal 6. In other words, the increased current amount $i_1$ is a sum of pass-through currents which flows from a power supply to ground through various transistors activated in response to the internal reset signal 6. On the other hand, $i_0$ represents a consumed current of the semiconductor integrated circuit 1A when the reset signal is not applied.

Here, a pass-through current of a CMOS inverter is discussed assuming that respective thresholds of an nMOS transistor and a pMOS transistor constituting the CMOS inverter are Vtn and Vtp, and a power supply voltage is $V_{DD}$. As shown in Figure 2, when an input signal Vin applied to the CMOS inverter ("RESET SIGNAL VOLTAGE" in Figure 2) rises up or falls down, during a transition period fulfilling the condition : $Vtn \leq Vin \leq V_{DD} - |Vtp|$, both of the nMOS transistor and the pMOS transistor of the CMOS inverter are turned on, so that a current flows from the power supply through the nMOS transistor and the pMOS transistor to the ground. This is a pass-through current. The pass-through current of the CMOS inverter greatly depends upon a load capacitance, and becomes maximum at the time of no load. Assuming that the power supply voltage is 5 V, and both of the thresholds Vtn and |Vtp| of the nMOS transistor and the pMOS transistor are 0.8 V, a peak value of the pass-through current reaches for example 0.5 mA.

Therefore, if the semiconductor integrated circuit 1A operates with the power supply voltage of 5 V and the consumed electric power of 0.1 W, the current $i_0$ is 20 mA. Accordingly, assuming that the reset signal is applied simultaneously to the CMOS inverters (not shown) in the logic circuit units 3A and 3B, the increased current amount $i_1$ reaches 30 mA to 50 mA in the case of 100 CMOS inverters and 300 mA to 500 mA in the case of 1000 CMOS inverters.

If such a large pass-through current flows from the power supply to the ground, namely, if a large current flows through the semiconductor integrated circuit 1A, noises appears on the power supply and the ground so that the power supply voltage and the ground voltage varies, and a latch-up resistance drops.

## Summary of the Invention

Accordingly, it is an object of the present invention to provide a semiconductor integrated circuit having a reset circuit, which has overcome the above mentioned defect of the conventional one.

Another object of the present invention is to provide a semiconductor integrated circuit having a reset circuit, configured to minimize noises appearing on the power supply voltage and the ground voltage and also to prevent generation of the latch-up phenomenon.

The above and other objects of the present invention are achieved in accordance with the present invention by a semiconductor integrated circuit having a plurality of logic circuit units and a reset circuit, wherein the reset circuit generates at different timings a plurality of internal reset signals, which are supplied to the plurality of logic circuit units, respectively.

Preferably, the reset circuit includes an input circuit receiving an external reset signal to generate a first internal reset signal, and (N-1) delay circuits (where N is a positive integer larger than 1) receiving the first internal reset signal and each generating a delayed internal reset signal, so that, N internal reset signals in total are generated at different timings.

With the above mentioned arrangement, a plurality of internal reset signals generated at different timings, are supplied to a plurality of logic circuit units, respectively. Therefore, the increased current peak at the time of a resetting can be decreased, so that the noises appearing on the power supply voltage and the ground voltage can be suppressed and a latch-up phenomenon can be prevented.

Therefore, if the semiconductor integrated circuit excluding the reset circuit is divided into N logic circuit units (where N is an positive integer larger than 1) which have substantially the same current amount increased when the logic circuit units are reset by the internal reset signals, and if N internal reset signals are generated at different timings, the increased current peak at the time of a resetting can be decreased to I/N of the increased current peak when all the N logic circuit units are reset at the same timing.

The above and other objects, features and advantages of the present invention will be apparent from the following description of preferred embodiments of the invention with reference to the accompanying drawings.

Brief Description of the Drawings

Figure 1 is a block diagram of a conventional semiconductor integrated circuit having a reset circuit;
Figure 2 is a pair of graphs showing a voltage change of the reset signal and a current change in the conventional semiconductor integrated circuit shown in Figure 1 when the reset signal is applied;
Figure 3 is a block diagram of a first embodiment of the semiconductor integrated circuit having a reset circuit in accordance with the present invention;
Figure 4 is a graph showing a current change in the semiconductor integrated circuit shown in Figure 3 when the reset signal is applied;
Figures 5A and 5B are graphs showing a relation between the delay time and the current change in the semiconductor integrated circuit shown in Figure 3;
Figure 6 is a block diagram of a second embodiment of the semiconductor integrated circuit having a reset circuit in accordance with the present invention;
Figure 7 is a graph showing a current change in the semiconductor integrated circuit shown in Figure 6 when the reset signal is applied; and
Figure 8 is a block diagram of a third embodiment of the semiconductor integrated circuit having a reset circuit in accordance with the present invention.

Description of the Preferred embodiments

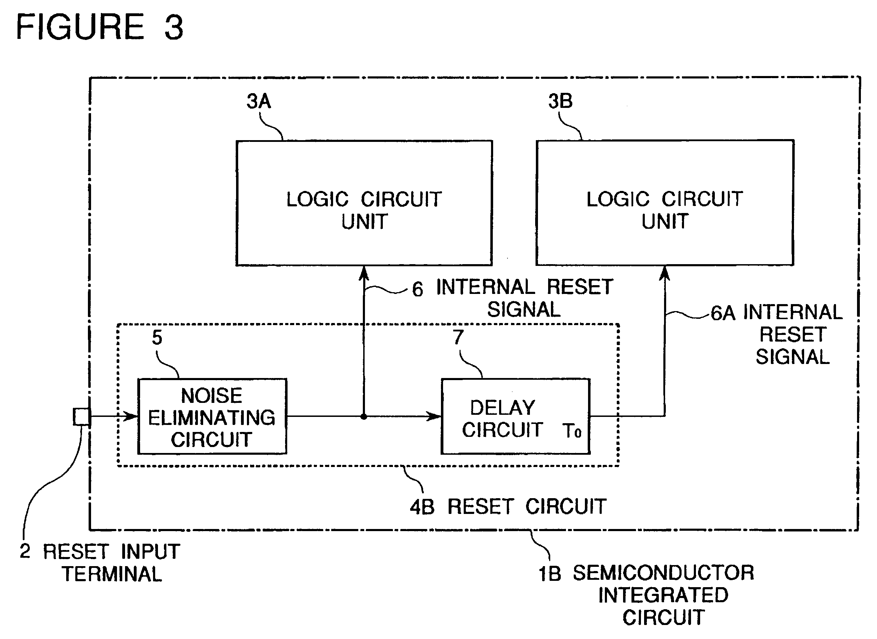

Referring to Figure 3, there is shown a block diagram of a first embodiment of the semiconductor integrated circuit having a reset circuit in accordance with the present invention.

The shown semiconductor integrated circuit is generally designated by Reference Numeral 1B, and has an external reset input terminal 2 for receiving an external reset signal and a reset circuit 4B having an input connected to the external reset input terminal 2. The semiconductor integrated circuit 1B excluding the reset circuit 4B is divided into two logic circuit units 3A and 3B. The reset circuit 4B includes a noise eliminating circuit 5 receiving the external reset signal supplied through the external reset input terminal 2 for generating a first internal reset signal 6, which is supplied to the logic circuit unit 3A. The reset circuit 4B also includes a delay circuit 7 of a delay time $T_0$ receiving the first internal reset signal 6 for outputting a second and delayed internal reset signal 6A, which is supplied to the logic circuit unit 3B.

In this embodiment, the semiconductor integrated circuit 1B excluding the reset circuit 4B is divided into the logic circuit units 3A and 3B so as to ensure the relation that the ratio of the increased amount of the consumed current in the logic circuit unit 3A in response to the internal reset signal 6 to the increased amount of the consumed current in the logic circuit unit 3B in response to the internal reset signal 6A, is K:L (where K and L are positive integer).

Now, assuming that $K = L = 1$, namely, the increased amount of the consumed current in the logic circuit unit 3A in response to the internal reset signal 6 is equal to the increased amount of the consumed current in the logic circuit unit 3B in response to the internal reset signal 6A, operation of the first embodiment will be described.

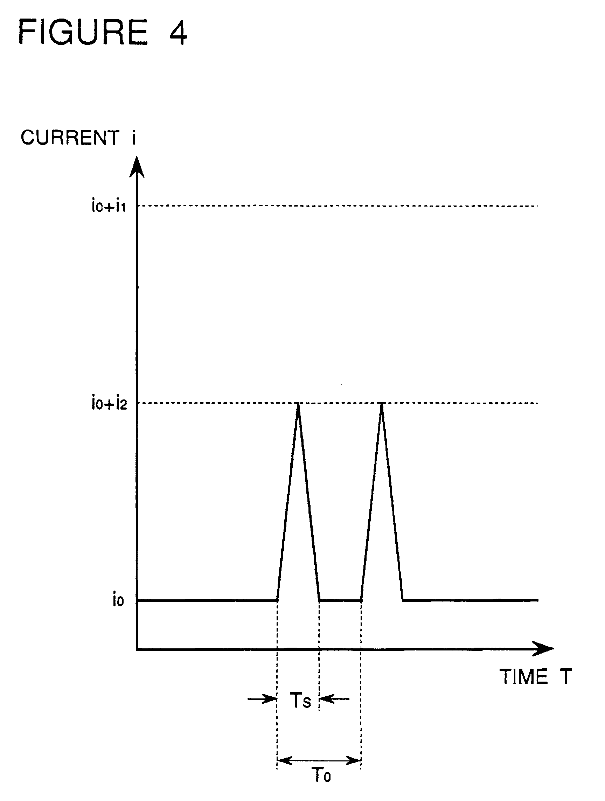

When the external reset signal is applied to the reset input terminal 2, the first internal reset signal 6 is activated for a first place, so that the logic circuit unit 3A is reset, with the result that the consumed current of the semiconductor integrated circuit 1B increases by $i_2$, as shown in Figure 4.

Here, $i_2$ is the increased amount of the consumed current in the logic circuit unit 3A when the logic circuit unit 3A is reset, and therefore, it can be expressed : $i_2 = (1/2) \times i_1$ where $i_1$ is the increased amount of the consumed current in the semiconductor integrated circuit 1B when the logic circuit units 3A and 3B were reset simultaneously by the reset signal 6. In Figure 4, Ts represents a time period in which a pass-through current flows.

After the delay time $T_0$ from the moment the first internal reset signal 6 was activated, the second internal reset signal 6A is activated, so that the logic circuit unit 3B is reset. As mentioned above, since the increased amount of the consumed current in the logic circuit unit 3A in response to the internal reset signal 6 is equal to the increased amount of the consumed current in the logic circuit unit 3B in response to the internal reset signal 6A ($K = L = 1$), the consumed current of the semiconductor integrated circuit 1B increases by $i_2$, again, after a delay of $T_0$ from the increase of the consumed current of the semiconductor integrated circuit 1B caused by resetting the logic circuit unit 3A.

Thus, by dividing the semiconductor integrated circuit 1B into the two logic circuit units 3A and 3B, and by generating the two internal reset signals 6 and 6A at different timings within the semiconductor integrated circuit 1B so as to supply the two internal reset signals 6 and 6A to the two logic circuit units 3A and 3B, respectively, so that the two logic circuit units 3A and 3B are reset at different timings, the number of transistors turned on simultaneously at the time of resetting is reduced, and in the case of $K = L = 1$, the increase of the consumed current of the semiconductor integrated circuit at the time of resetting is reduced to one half.

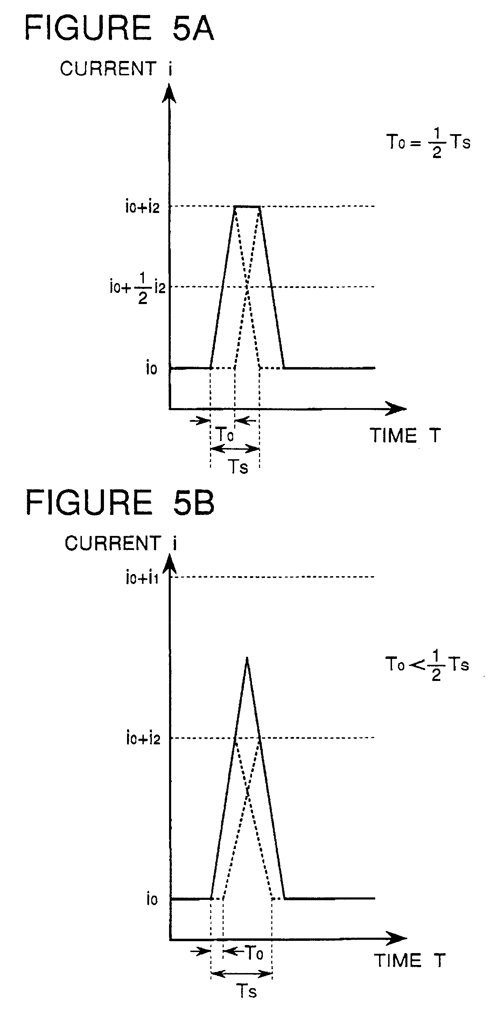

Here, assuming that the delay time of the delay circuit 7 is $T_0$ and the time period in which the pass-through current flows is Ts under the assumption that a waveform of the pass-through current is substantially an isosceles triangle, the case shown in Figure 4 corresponds to a situation of $T_0 > Ts$, and the maximum current of the semiconductor integrated circuit is $i_0 + i_2$ (where $i_2 = (1/2)i_1$). If $T_0 = (1/2)Ts$, the maximum current of the semiconductor integrated circuit also becomes $i_0 + i_2$, as shown in Figure 5A. Therefore, if $T_0 \geqq (1/2)Ts$, the maximum current is $i_0 + i_2$.

As shown in Figure 5B, however, if $T_0 < (1/2)Ts$, the pass-through current in the logic circuit unit 3A considerably overlaps the pass-through current in the logic circuit unit 3B in time, so that the maximum current exceeds $i_0 + i_2$. Therefore, it is preferred to set $T_0 \geqq (1/2)Ts$. As a matter of course, however, it cannot be said that the larger the delay time $T_0$ is, it is more preferable. The delay time $T_0$ is to be set within such a range that the semiconductor integrated circuit never malfunctions.

Assuming that "I" represents the increased amount of the consumed current in the semiconductor integrated circuit when the both of the logic circuit units 3A and 3B were reset simultaneously, it can be generally said in the first embodiment that, in the case of $K \geqq L$, the increased amount of the consumed current in the semiconductor integrated circuit can be decreased to $\{K/(K + L)\} \times I$.

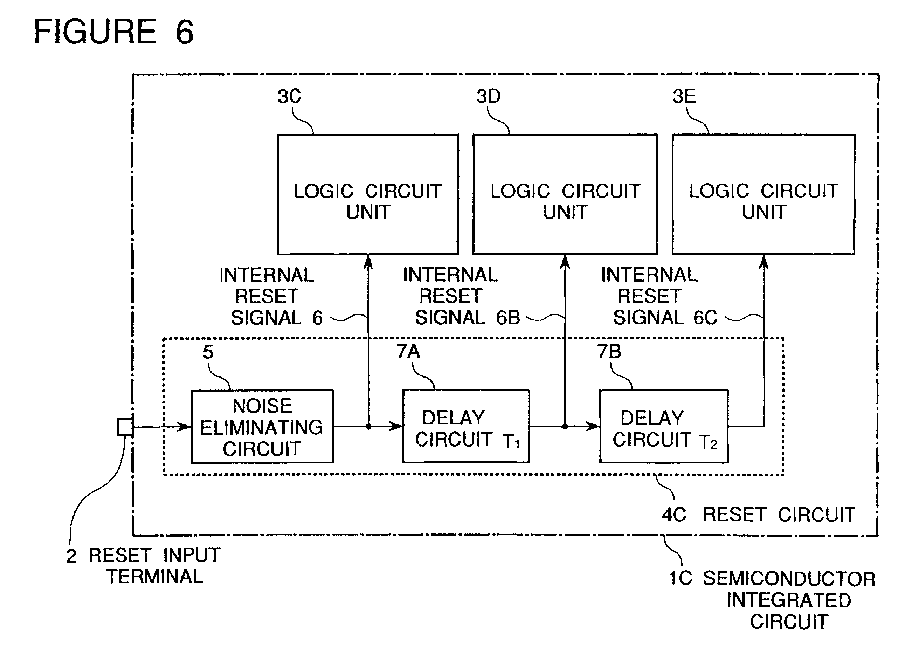

Referring to Figure 6, there is shown a block diagram of a second embodiment of the semiconductor integrated circuit having a reset circuit in accordance with the present invention.

The second semiconductor integrated circuit is generally designated by Reference Numeral 1C, and has an external reset input terminal 2 for receiving an external reset signal and a reset circuit 4C having an input connected to the external reset input terminal 2. The semiconductor integrated circuit 1C excluding the reset circuit 4C is divided into three logic circuit units 3C, 3D and 3E. The reset circuit 4C includes a noise eliminating circuit 5 receiving the external reset signal supplied through the external reset input terminal 2 for generating a first internal reset signal 6, which is supplied to the logic circuit unit 3C. The reset circuit 4C also includes a delay circuit 7A of a delay time $T_1$ receiving the first internal reset signal 6 for outputting a second and delayed internal reset signal 6B, which is supplied to the logic circuit unit 3D. Furthermore, the reset circuit 4C includes a delay circuit 7B of a delay time $T_2$ receiving the second and delayed internal reset signal 6B for outputting a third and delayed internal reset signal 6C, which is supplied to the logic circuit unit 3D.

In this second embodiment, the semiconductor integrated circuit 1C excluding the reset circuit 4C is divided into the logic circuit units 3C, 3D and 3E so as to ensure the relation that the increased amount of the consumed current in the logic circuit unit 3C in response to the internal reset signal 6, the increased amount of the consumed current in the logic circuit unit 3D in response to the internal reset signal 6B, and the increased amount of the consumed current in the logic circuit unit 3E in response to the internal reset signal 6C, are in proportion of K:L:M (where K, L and M are positive integer).

As the most typical example, assuming that $K = L = M = 1$, namely, the increased amount of the consumed current in the three logic circuit units in response to the internal reset signal are equal to each other, operation of the second embodiment will be described.

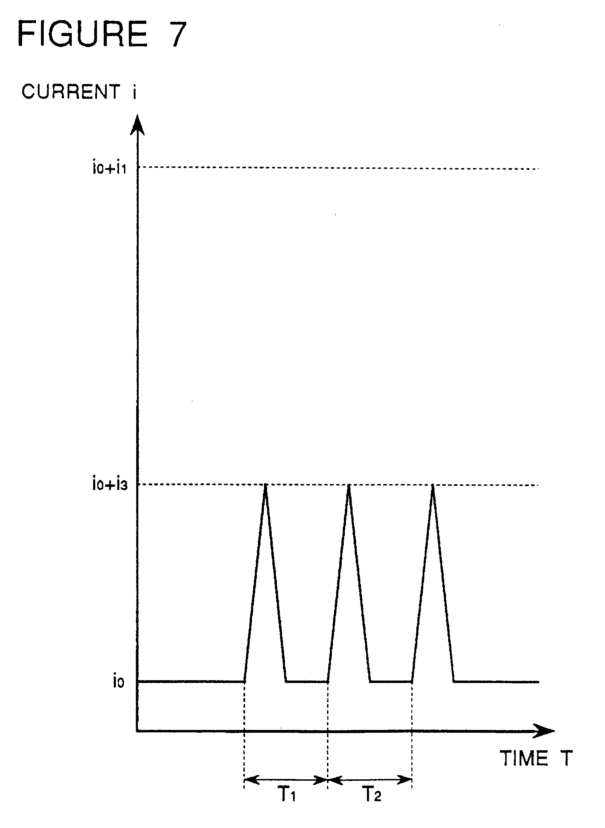

When the external reset signal is applied to the reset input terminal 2, the first internal reset signal 6 is activated for a first place, so that the logic circuit unit 3C is reset, with the result that the consumed current of the semiconductor integrated circuit 1C increases by $i_3$, as shown in Figure 7.

Here, $i_3$ is the increased amount of the consumed current in the logic circuit unit 3C when the logic circuit unit 3C is reset, and therefore, it can be expressed : $i_3 = (1/3) \times i_1$ where $i_1$ is the increased amount of the consumed current in the semiconductor integrated circuit 1C when the three logic circuit units 3C, 3D and 3E were reset simultaneously by the reset signal 6.

After the delay time $T_1$ from the moment the first internal reset signal 6 was activated, the second internal reset signal 6B is activated, so that the logic circuit unit 3D is reset. Therefore, the consumed current of the semiconductor integrated circuit 1C increases by $i_3$, again, after a delay of $T_1$ from the increase of the consumed current of the semiconductor integrated circuit 1C caused by resetting the logic circuit unit 3C.

Furthermore, after the delay time $T_2$ from the moment the second internal reset signal 6B was activated, the third internal reset signal 6C is activated, so that the logic circuit unit 3E is reset. Therefore, the consumed current of the semiconductor integrated circuit 1C increases by $i_3$, again, after a delay of $T_2$ from the increase of the consumed current of the semiconductor integrated circuit 1C caused by resetting the logic circuit unit 3D.

Thus, by dividing the semiconductor integrated circuit 1C into the three logic circuit units 3C, 3D and 3E, and by generating the three internal reset signals 6, 6B and 6C at different timings within the semiconductor integrated circuit 1C so as to supply the three internal reset signals 6, 6B and 6C to the three logic circuit units 3C, 3D and 3E, respectively, so that the three logic circuit units 3C, 3D and 3E are reset at different timings, the number of transistors turned on simultaneously at the time of resetting is reduced, and in the case of $K = L = M = 1$, the increase of the consumed current of the semiconductor integrated circuit at the time of resetting is reduced to one third.

Assuming that "I" represents the increased amount of the consumed current in the semiconductor integrated circuit when all of the logic circuit units 3C, 3D and 3E were reset simultaneously, it can be generally said in the second embodiment that, in the case of $K \geq L \geq M$, the increased amount of the consumed current in the semiconductor integrated circuit can be decreased to $\{K/(K + L + M)\} \times I$.

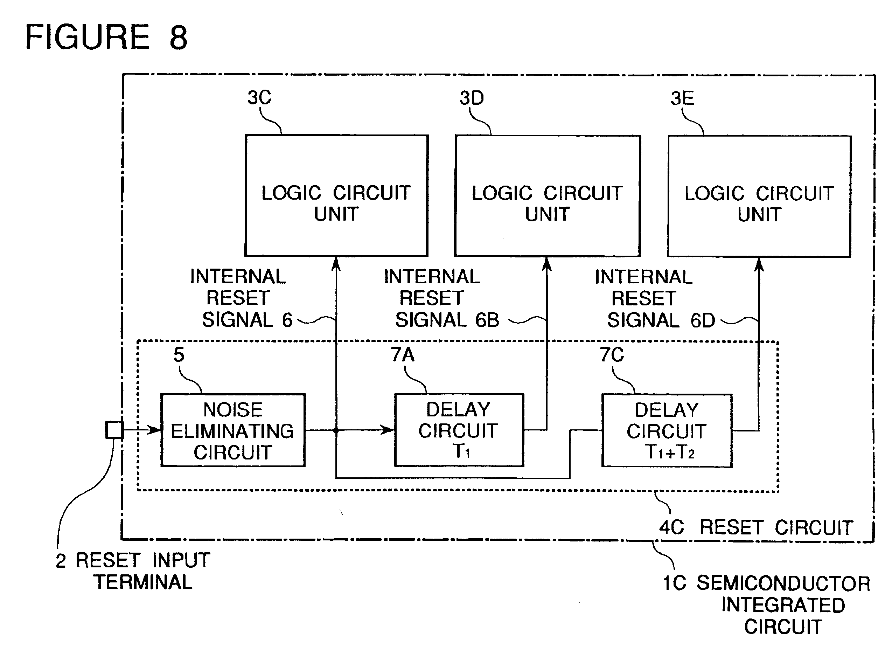

Referring to Figure 8, there is shown a block diagram of a third embodiment of the semiconductor integrated circuit having a reset circuit in accordance with the present invention. In Figure 8, elements similar to those shown in Figure 6 are given the same Reference Numerals, and explanation thereof will be omitted for simplification of the description.

As seen from comparison between Figures 6 and 8, the third embodiment is different from the second embodiment in that the third embodiment includes, in place of the delay circuit 7B, a delay circuit 7C having a delay time of $T_1 + T_2$ and receiving the first internal reset signal 6 for outputting a third and delayed internal reset signal 6D to the logic circuit unit 3E. Namely, the delay circuit 7C is connected in parallel to the delay circuit 7A.

Therefore, since the internal reset signal 6D is substantially the same as the internal reset signal 6C, the third embodiment operates similarly to the second embodiment, and therefore, explanation of operation of the third embodiment will be omitted.

Accordingly, generally speaking, if (N-1) delay circuits are cascaded after the noise eliminating circuit 5 in such a manner that a first one of the delay circuits receives the first internal reset signal and a second one of the delay circuits receives an output of the first one, and so on, or if (N-1) delay circuits having different delay times are connected in parallel to each other to receive the internal reset signal outputted from the noise eliminating circuit 5, so that N internal reset signals in total are generated at different timings from the noise eliminating circuit 5 and the (N-1) delay circuits within the semiconductor integrated circuit, and if the semiconductor integrated circuit excluding the reset circuit is divided into N logic circuit units receiving the N different internal reset signals, respectively, the N logic circuit units are reset at the N different timings, and therefore, the increased amount of the consumed current caused by the resetting can be reduced.

In this case, if the semiconductor integrated circuit excluding the reset circuit is divided in such a manner that the N logic circuit units have substantially the same increased amount of the consumed current caused by the resetting, the increased amount of the consumed current caused by the resetting can be reduced to I/N in comparison with the case in which all the circuits within the semiconductor integrated circuit are reset simultaneously.

Incidentally, the delay circuits 7 and 7A to 7C can be formed of an inverter or cascaded inverters or a combination of an inverter and a capacitor, as well known to persons skilled in the art.

The invention has thus been shown and described with reference to the specific embodiments. However, it should be noted that the present invention is in no way limited to the details of the illustrated structures but changes and modifications may be made.

**Claims**

1.  A semiconductor integrated circuit having a plurality of logic circuit units and a reset circuit, wherein said reset circuit generates at different timings a plurality of internal reset signals, which are supplied to said plurality of logic circuit units, respectively.

2.  A semiconductor integrated circuit claimed in Claim 1 wherein said reset circuit includes an input circuit receiving an external reset signal to generate a first internal reset signal, and (N-1) delay circuits (where N is a positive integer larger than 1) receiving said first internal reset signal and each generating a delayed internal reset signal, so that, N internal reset signals in total are generated at different timings.

3. A semiconductor integrated circuit claimed in Claim 2 wherein said (N-1) delay circuits are cascaded.

4. A semiconductor integrated circuit claimed in Claim 2 wherein said (N-1) delay circuits are connected in parallel to each other so that each of said (N-1) delay circuits receives said output of said input circuit, and said (N-1) delay circuits have different delay times, so that said N delayed internal reset signals are generated at different timings from said internal circuit and said (N-1) delay circuits, respectively.

5. A semiconductor integrated circuit claimed in Claim 2 wherein said plurality of logic circuit units have substantially the same current amount increased when said logic circuit units receive the internal reset signals.

6. A semiconductor integrated circuit having at least an external reset input terminal and a reset circuit receiving an external reset signal through said external reset input terminal, the semiconductor integrated circuit excluding said reset circuit being divided into a plurality of logic circuits units, and said reset circuit including an input circuit receiving said external reset signal to generate a first internal reset signal, and a plurality of delay circuits receiving said first internal reset signal and each generating a delayed internal reset signal at a different timing, said first internal reset signal outputted from said input circuit and said delayed internal reset signals outputted from said delay circuits, respectively, being supplied to said plurality of logic circuits units, respectively, so that said plurality of logic circuits units are reset at different timings.

7. A semiconductor integrated circuit claimed in Claim 6 wherein said delay circuits are cascaded in such a manner that a first one of said delay circuits receives said first internal reset signal and a second one of said delay circuits receives an output of said first one, and so on.

8. A semiconductor integrated circuit claimed in Claim 6 wherein said delay circuits are connected in parallel to each other so that each of said delay circuits receives said first internal reset signal, and said delay circuits have different delay times, so that delayed internal reset signals are generated at different timings from said delay circuits.

9. A semiconductor integrated circuit claimed in Claim 6 wherein said plurality of logic circuit units have substantially the same current amount increased when said logic circuit units receive the internal reset signals.

# FIGURE 1 PRIOR ART

3A

3B

LOGIC CIRCUIT
UNIT

LOGIC CIRCUIT
UNIT

5

6 INTERNAL RESET
SIGNAL

NOISE
ELIMINATING
CIRCUIT

4A RESET CIRCUIT

2 RESET INPUT
TERMINAL

1A SEMICONDUCTOR
INTEGRATED
CIRCUIT

EP 0 689 290 A1

7

# FIGURE 2 PRIOR ART

RESET SIGNAL
VOLTAGE Vin

$V_{DD}$

$V_{DD}-|V_{tp}|$

$V_{tn}$

TIME

CURRENT i

$i_0+i_1$

$i_0$

TIME

# FIGURE 3

FIGURE 3 — Block diagram showing 1B SEMICONDUCTOR INTEGRATED CIRCUIT containing LOGIC CIRCUIT UNIT 3A and LOGIC CIRCUIT UNIT 3B, with 4B RESET CIRCUIT comprising NOISE ELIMINATING CIRCUIT 5 and DELAY CIRCUIT 7 ($T_0$). 2 RESET INPUT TERMINAL, 6 INTERNAL RESET SIGNAL, 6A INTERNAL RESET SIGNAL.

# FIGURE 4

CURRENT i

$i_0+i_1$

$i_0+i_2$

$i_0$

TIME T

Ts

T$_0$

# FIGURE 5A

# FIGURE 5B

# FIGURE 6

3C  LOGIC CIRCUIT UNIT

3D  LOGIC CIRCUIT UNIT

3E  LOGIC CIRCUIT UNIT

INTERNAL RESET SIGNAL 6

INTERNAL RESET SIGNAL 6B

INTERNAL RESET SIGNAL 6C

5  NOISE ELIMINATING CIRCUIT

7A  DELAY CIRCUIT $T_1$

7B  DELAY CIRCUIT $T_2$

4C  RESET CIRCUIT

2  RESET INPUT TERMINAL

1C  SEMICONDUCTOR INTEGRATED CIRCUIT

EP 0 689 290 A1

# FIGURE 7

CURRENT i

$i_0+i_1$

$i_0+i_3$

$i_0$

TIME T

$T_1$  $T_2$

# FIGURE 8

3C — LOGIC CIRCUIT UNIT

3D — LOGIC CIRCUIT UNIT

3E — LOGIC CIRCUIT UNIT

INTERNAL RESET SIGNAL 6

INTERNAL RESET SIGNAL 6B

INTERNAL RESET SIGNAL 6D

5 — NOISE ELIMINATING CIRCUIT

7A — DELAY CIRCUIT $T_1$

7C — DELAY CIRCUIT $T_1+T_2$

4C RESET CIRCUIT

2 RESET INPUT TERMINAL

1C SEMICONDUCTOR INTEGRATED CIRCUIT

EP 0 689 290 A1

## DOCUMENTS CONSIDERED TO BE RELEVANT

EP 95109742.7

| Category | Citation of document with indication, where appropriate, of relevant passages | Relevant to claim | CLASSIFICATION OF THE APPLICATION (Int. Cl. 6) |
|---|---|---|---|
| X | PATENT ABSTRACTS OF JAPAN, unexamined applications, E field, vol. 17, no. 150, November 09, 1992 THE PATENT OFFICE JAPANESE GOVERNMENT page 130 E 1339; & JP-A-04 317 211 (NEC) * Totality * | 1,2 | H 03 K 5/15 |
| A | | 3-9 | |
| P,X | DATABASE WPIL, no. 95-235 691, DERWENT PUBLICATIONS LTD., London; & JP-A-07 142 963 (NIPPON DENKI) * Abstract * | 1,2,6 | |
| P,A | | 3-5, 7-9 | **TECHNICAL FIELDS SEARCHED (Int. Cl.6)** |
| A | US - A - 3 622 809 (WILLIAMS) * Abstract; fig. * | 3,7 | H 03 K 3/00 H 03 K 5/00 |
| A | US - A - 4 420 696 (GEMMA et al.) * Abstract; fig. * | 4,8 | H 03 K 17/00 H 03 K 19/00 |

The present search report has been drawn up for all claims

| Place of search | Date of completion of the search | Examiner |
|---|---|---|
| VIENNA | 19-09-1995 | FELLNER |